(19) **Europäisches Patentamt European Patent Office Office européen des brevets**

(11) **EP 4 542 795 B1**

(12) **FASCICULE DE BREVET EUROPEEN**

(45) Date de publication et mention de la délivrance du brevet:
**11.03.2026 Bulletin 2026/11**

(51) Classification Internationale des Brevets (IPC):
*H01S 3/08036* (2023.01)  *H01S 3/08* (2023.01)
*H01S 3/10* (2006.01)  *H01S 3/107* (2006.01)
*H01S 3/17* (2006.01)  *H01S 5/062* (2006.01)
*H01S 5/14* (2006.01)

(21) Numéro de dépôt: **24207582.8**

(22) Date de dépôt: **18.10.2024**

(52) Classification Coopérative des Brevets (CPC):
**H01S 3/0809; H01S 3/08036; H01S 3/08054; H01S 3/10061; H01S 3/107; H01S 3/17; H01S 5/0622; H01S 5/141**

(54) **SOURCE LASER ACCORDABLE BI-POLARISATION ET BI-FRÉQUENCE**

ABSTIMMBARE BIPOLARISATIONS- UND BIFREQUENZ-LASERQUELLE.

DUAL-FREQUENCY BI-POLARIZATION TUNABLE LASER SOURCE.

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **19.10.2023 FR 2311307**

(43) Date de publication de la demande:
**23.04.2025 Bulletin 2025/17**

(73) Titulaire: **THALES**
**92190 Meudon (FR)**

(72) Inventeurs:
- **MORVAN, Loïc**
  **91400 Orsay (FR)**
- **GUTTY, François**
  **91400 Orsay (FR)**
- **BAILI, Ghaya**
  **91120 Palaiseau (FR)**
- **CROZATIER, Vincent**
  **78830 Bonnelles (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**FR-A1- 2 886 478**

- **LIU X ET AL: "Towards the detection of high-contrast Cs CPT resonances using a single modulated diode laser", EUROPEAN FREQUENCY AND TIME FORUM (EFTF), 2012, IEEE, 23 April 2012 (2012-04-23), pages 304 - 308, XP032375822, ISBN: 978-1-4673-1924-9, DOI: 10.1109/EFTF.2012.6502388**
- **WARREN Z ET AL: "Experimental and theoretical comparison of different optical excitation schemes for a compact coherent population trapping Rb vapor clock", METROLOGIA, INSTITUTE OF PHYSICS PUBLISHING, BRISTOL, GB, vol. 54, no. 4, 14 June 2017 (2017-06-14), pages 418 - 431, XP020317994, ISSN: 0026-1394, [retrieved on 20170614], DOI: 10.1088/1681-7575/AA72BB**
- **L. MORVAND. DOLFIJ.P.HUIGNARDS. BLANCM. BRUNELF. BRETENAKERM. VALLETA. LE FLOCH: "Dual-frequency laser at 1.53 m for generating high purity optically carried microwave signals up to 20 GHz", CLEO, 2004, XP002811796**

**Description**

<u>Domaine technique</u> :

La présente invention concerne le domaine des lasers bi-fréquence et bi-polarisation accordables.

<u>Technique antérieure</u> :

Les lasers présentent un nombre très important d'applications. Ils sont par exemple utilisés pour transporter optiquement des signaux hyperfréquence (fréquence dans les gigahertz) sur de très grandes distances et en apportant très peu de bruit au signal à transporter. Parmi les techniques possibles, l'utilisation d'un laser bi-fréquence, c'est-à-dire qui émet spontanément deux modes laser, et dont la différence de fréquence est égale à la fréquence du signal que l'on veut transporter est particulièrement intéressante parce qu'elle permet de générer ce signal en maximisant sa profondeur de modulation. D'autre part, le signal est ainsi transféré sur une onde porteuse optique qui peut présenter un très faible bruit d'intensité relatif et ainsi contribuer à conserver la bonne qualité initiale du signal.

En plus du transport de signaux électriques sur voie optique, les sources laser émettant deux faisceaux de fréquences différentes trouvent des applications dans un grand nombre de domaines comme la spectroscopie, la mesure de bande passante de composants optoélectroniques, la génération et la détection d'ondes dans le domaine TéraHertz et même le lidar. Certains de ces domaines mettent en jeu la détection du battement hétérodyne entre les deux faisceaux, et dans ce cas la qualité spectrale du battement généré est importante.

Il existe plusieurs architectures de sources laser délivrant deux fréquences connues de l'homme de l'art.

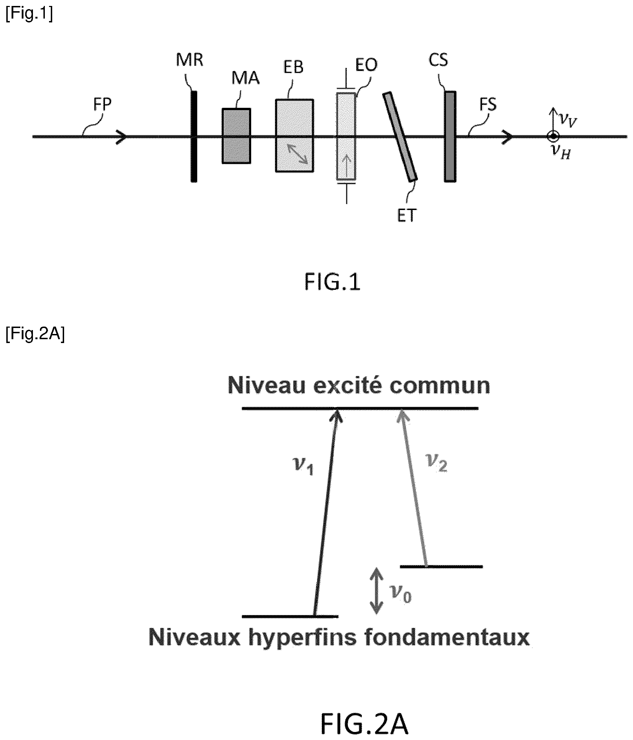

Afin de présenter un bruit d'intensité le plus faible possible, il est identifié que la meilleure architecture générale du laser doit reposer sur une cavité linéaire qui comporte des éléments biréfringents et électro-optiques comme illustré en figure 1.

Plus précisément, ce type de cavité laser comprend un miroir hautement réfléchissant MR, un milieu actif MA, un élément biréfringent EB, un cristal électro-optique EO, un étalon ET et un coupleur de sortie CS transmettant un faisceau de sortie FS. A titre d'exemple, le milieu actif MA est pompé optiquement par un faisceau de pompe FP.

L'étalon ET est un interféromètre Fabry-Pérot servant de filtre modal intra-cavité. Il assure ainsi un fonctionnement monomode longitudinal sur chaque état de polarisation de fréquence $v_H$ et $v_V$.

Le milieu actif MA permettant le gain laser est typiquement une structure active semi-conductrice, pompée optiquement. Les deux fréquences $v_H$ et $v_V$ d'oscillation du laser sont associées à deux polarisations linéaires perpendiculaires et croisées, et superposées dans la cavité laser.

L'écart de fréquence $\Delta v = v_H - v_V$ est lié au déphasage relatif $\Delta\phi$ introduit par les éléments biréfringents de la cavité à la longueur d'onde laser et à la longueur optique L de la cavité : $\Delta v = c.\Delta\phi/2\pi L$ où c est la célérité de la lumière dans le vide. En effet, l'élément biréfringent EB permet d'assurer naturellement une émission bipolarisation. Le cristal EO introduit une biréfringence supplémentaire dans la cavité.

L'intérêt du laser bi-fréquence est que les deux faisceaux partagent la même cavité optique et donc qu'une partie des perturbations que celle-ci subit n'induisent qu'au deuxième ordre un effet sur le battement. De plus, il est possible de séparer en polarisation les deux faisceaux émis ce qui présente un intérêt pour nombre d'applications. Enfin, la différence de fréquence est accordable en ajustant la valeur de la biréfringence mécaniquement, thermo-optiquement, ou électro-optiquement selon le type de matériau biréfringent utilisé. Dans ce dernier cas il est possible d'asservir en phase à une référence externe le battement généré (L. Morvan, D. Dolfi, J.P.Huignard, S. Blanc, M. Brunel, F. Bretenaker, M. Vallet, A. Le Floch, "Dual-frequency laser at 1.53 μm for generating high purity optically carried microwave signals up to 20 GHz", CLEO, paper CtuL5, San Francisco, 2004; M. Alouini, B. Benazet, M. Vallet, M. Brunel, P. Di Bin, F. Bretenaker, A. Le Floch and P. Thony, « Offset phase locking of Er:Yb:Glass laser eigenstates for RF photonics applications » , IEEE Photonics Technology Letters 13, 367-369, 2001).

Pour être utilisé dans l'interrogation optique d'une horloge atomique, le laser bipolarisation bi-fréquence doit permettre un réglage indépendant des deux fréquences optiques, ou de pouvoir régler indépendamment une fréquence optique et la différence de fréquence entre les deux.

Pour permettre cela, il est connu d'ajuster la longueur totale de la cavité par le déplacement du miroir hautement réfléchissant MR ou du coupleur de sortie CS (typiquement monté sur un transducteur piézoélectrique) et de régler une tension appliquée au sein du cristal électro-optique EO via deux électrodes.

La combinaison d'un étalon et d'un élément électro-optique fournissant l'accordabilité peut être remplacée par un étalon anisotrope accordable comme décrit dans la demande FR2886478A1.

En effet, les fréquences optiques émises $v_H$ et $v_V$ sont inversement proportionnelles à la longueur optique vue par chaque mode de polarisation et peuvent s'exprimer selon les équations ci-dessous :

$$v_H = p \times \frac{c}{2\,L_{cav,H}}$$

$$v_V = q \times \frac{c}{2\,L_{cav,V}}$$

où les entiers $p$ et $q$ désignent respectivement les ordres des modes de cavité de polarisation horizontale et verticale, et $L_{cav,H}$ et $L_{cav,V}$ représentent respectivement les longueurs optiques de la cavité vues par les modes de polarisation horizontale et verticale, incluant les chemins optiques dans l'élément biréfringent (d'épaisseur $e_{PBS}$ et d'indices $n_{PBS}^H$ et $n_{PBS}^V$ différents pour les deux polarisations), le chemin optique dans l'élément électro-optique (d'épaisseur $e_{EO}$ et d'indices $n_{EO}^H$ et $n_{EO}^V$ différents pour les deux polarisations).

Ces longueurs optiques peuvent s'exprimer en fonction de la longueur géométrique de la cavité $L_{cav}^{géom}$ (distance entre la structure semi-conductrice et le miroir coupleur de sortie) selon l'expression ci-dessous :

$$L_{cav,H} = L_{cav}^{géom} + (n_{PBS}^H - 1)e_{PBS} + (n_{EO}^H - 1)e_{EO}$$

$$L_{cav,V} = L_{cav}^{géom} + (n_{PBS}^V - 1)e_{PBS} + (n_{EO}^V - 1)e_{EO}$$

Dans le cas d'une cavité comprenant un cristal électro-optique contrôlable en tension, l'application d'une tension provoque une modification simultanée des indices $n_{EO}^H$ et $n_{EO}^V$ perçus par les modes de polarisations perpendiculaires et de fréquence $v_H$ et $v_V$. Cette modification est différente pour les deux polarisations qui voient la longueur effective de la cavité modifiée de façon différente. La fréquence optique émise sur chaque polarisation étant inversement proportionnelle à cette longueur, les deux fréquences varient toutes les deux mais avec une amplitude différente. L'application de la tension conduit donc à modifier simultanément la fréquence optique de chaque mode de polarisation ainsi que leur écart en fréquence.

La solution de l'art antérieur présente donc l'inconvénient de ne pas permettre de régler indépendamment les fréquences optiques des deux modes émis. Ce contrôle indépendant des deux fréquences optiques des deux modes émis est particulièrement pertinent pour le pompage d'horloges atomiques à interrogation tout-optique.

En effet, parmi les différentes architectures d'horloges atomiques, celles basées sur le phénomène de piégeage cohérent des populations (Coherent Population Trapping, ou CPT) reposent sur l'interrogation optique d'une transition atomique hyperfréquence à l'aide de deux fréquences optiques $v_1, v_2$ dont l'écart de fréquence $v_2 - v_1 = v_0$ est proche et accordable autour de la transition interrogée (voir figure 2A).

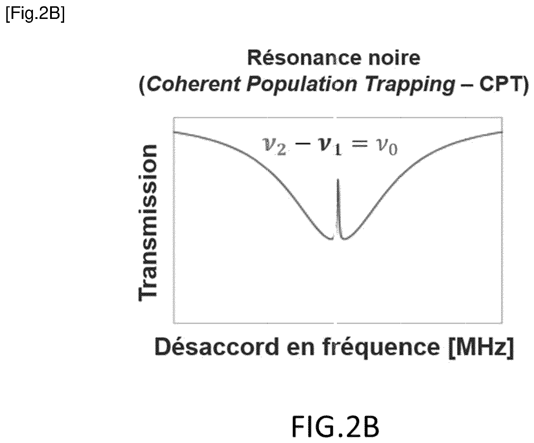

Lorsque ces deux fréquences optiques $v_1, v_2$ de polarisations perpendiculaires et croisées traversent une cellule de vapeur d'atomes, la transmission de la cellule fixée par l'absorption de la vapeur d'atomes augmente suivant une raie très étroite lorsque la différence de fréquence entre les ondes optiques $v_2 - v_1 = v_0$ est exactement égale à la fréquence de transition atomique hyperfréquence (voir figure 2B).

L'utilisation de fréquences optiques qui présentent des polarisations perpendiculaires et croisées permet de maximiser le contraste de cette raie (« raie CPT »).

Dans le cas de l'utilisation d'une vapeur d'atomes de césium, les fréquences optiques peuvent correspondre à la raie d'absorption $D_1$ (895 nm) ou à la raie $D_2$ (852 nm). Comme la largeur intrinsèque de la raie CPT est très étroite (quelques dizaines de kHz) en comparaison de la raie d'absorption optique (typiquement le GHz) et relativement indépendante de l'environnement, ces résonances noires ont tout particulièrement trouvé une application dans la réalisation d'horloges atomiques.

Une solution est ainsi d'utiliser un laser bi-fréquence émettant deux modes de polarisations linéaires et perpendiculaires (bipolarisation) dont la différence de fréquence est accordable autour de la transition atomique de référence à interroger (dans le domaine des gigahertz) et dont les longueurs d'ondes absolues sont réglables pour être absorbées par les atomes choisis. Pour y parvenir, le laser bi-fréquence bipolarisation doit pouvoir permettre un réglage indépendant de la longueur d'onde absolue et de la différence de fréquence (ou un contrôle indépendant des deux fréquences optiques des deux modes). Le laser doit également présenter un bruit d'intensité le plus faible possible afin de bénéficier du meilleur rapport signal à bruit dans l'asservissement sur la raie CPT et d'avoir l'horloge la plus stable possible dès le court-terme (temps d'intégration de 1 s).

En outre, le laser bifréquence et bi-polarisation de la figure 1 présente des dérives importantes au cours du temps. En effet, les cristaux électro-optiques EO utilisés dans la cavité laser sont très sensibles à l'effet thermo-optique : leurs indices (ordinaire et extraordinaire) varient très rapidement avec la température. Donc même lorsqu'un point de fonctionnement intéressant est trouvé, la solution décrite précédemment présente l'inconvénient d'être très sensible à la température des éléments puisque toute dérive affectera simultanément la fréquence des deux modes ainsi que leur différence.

L'invention vise à pallier certains problèmes de l'art antérieur. Plus précisément, l'invention porte sur une source laser accordable bi-polarisation et bi-fréquence émettant une première fréquence optique et une deuxième fréquence optique. Par différence avec l'art antérieur, le laser de l'invention comprend deux cristaux électro-optiques chacun muni d'une paire d'électrodes respective et disposés judicieusement l'un par rapport à l'autre. Par un contrôle judicieux des tensions appliquées entre les paires d'électrodes et par une orientation particulière de l'axe optique de chaque cristal électro-optique, il est possible de contrôler indépendamment une valeur des deux fréquences optiques émises par le laser.

Le document "Towards the detection of high-contrast Cs CPT resonances using a single modulated diode laser",EUROPEAN FREQUENCY AND TIME FORUM (EFTF), 2012, IEEE, 23 avril 2012 (2012-04-23), pages 304-308, décrit une horloge atomique à piégeage cohérent de population comprenant un système laser bi-fréquence bi-polarisation.

**Résumé de** l'invention :

A cet effet, un objet de l'invention est une source laser accordable bi-polarisation et bi-fréquence adaptée pour émettre un faisceau de sortie présentant une première fréquence $v_V$ selon une première polarisation linéaire et une deuxième fréquence $v_H$ selon une deuxième polarisation linéaire perpendiculaire à la première polarisation linéaire, la source laser comprenant une cavité optique adaptée pour propager un faisceau laser intra-cavité entre :

- un élément hautement réfléchissant à la première fréquence $v_V$ et à la deuxième fréquence $v_H$, et
- un coupleur de sortie adapté pour transmettre une portion du faisceau laser intra-cavité de manière à former le faisceau de sortie et pour réfléchir une autre portion du faisceau laser intra-cavité, une distance, entre l'élément hautement réfléchissant et le coupleur de sortie étant appelée longueur de cavité, la cavité optique comprenant les éléments suivants disposés entre l'élément hautement réfléchissant et le coupleur de sortie:

  - un milieu actif adapté pour présenter un gain optique à la première fréquence $v_V$ et à la deuxième fréquence $v_H$ lorsqu'il est pompé électriquement ou optiquement de manière à amplifier le faisceau laser intra-cavité
  - au moins un élément biréfringent adapté(s) pour présenter une biréfringence telle que le faisceau laser intra-cavité présente la première fréquence $v_V$ selon la première polarisation linéaire et présente la deuxième fréquence $v_H$ selon la deuxième polarisation linéaire
  - un étalon Fabry-Perot ou ladite longueur de cavité étant adapté(e) pour que le faisceau laser intra-cavité présente uniquement deux modes longitudinaux, un premier mode longitudinal à la première fréquence $v_V$ et un deuxième mode longitudinal à la deuxième fréquence $v_H$
  - un premier cristal électro-optique dans un premier matériau présentant un premier axe optique avec une même direction que la première polarisation linéaire et comprenant une première paire d'électrodes adaptée pour appliquer au sein du premier cristal électro-optique une première tension $V_1$ selon une direction de la première polarisation linéaire
  - un deuxième cristal électro-optique dans un deuxième matériau présentant un deuxième axe optique avec une même direction que la deuxième polarisation linéaire et comprenant une deuxième paire d'électrodes adaptée pour appliquer au sein du deuxième cristal électro-optique une deuxième tension $V_2$ selon une direction de la deuxième polarisation linéaire, le premier et le deuxième matériaux étant adaptés pour qu'il existe une première et une deuxième tensions $V_1, V_2$ adaptées pour contrôler indépendamment une valeur de la première fréquence $v_V$ et une valeur de la deuxième fréquence $v_H$ comprises dans le faisceau de sortie.

Selon un mode de réalisation préféré, pour une première tension $V_1$ appliquée au sein du premier cristal électro-optique et pour une deuxième tension $V_2$ appliquée au sein du deuxième cristal électro-optique, la première fréquence $v_V$ varie d'une valeur $\Delta v_V(V_1, V_2)$ et la deuxième fréquence $v_H$ varie d'une valeur $\Delta v_H(V_1, V_2)$ telles qu'on obtient le système d'équation suivant :

$$\begin{cases} \Delta v_V(V_1, V_2) = aV_1 + bV_2 \\ \Delta v_H(V_1, V_2) = cV_1 + dV_2 \end{cases}$$

avec a et c des coefficients dépendant de la susceptibilité électrique du premier matériau et avec b et d des coefficients dépendant de la susceptibilité électrique du deuxième matériau, le premier matériau et le deuxième matériau étant tels qu'un discriminant du système d'équation soit supérieur à 0.

Selon un premier mode de réalisation, la source laser de l'invention comprend un demi-VCSEL comprenant une région à gain formant ledit milieu actif et comprenant un miroir inférieur de Bragg formant ledit élément hautement réfléchissant, ledit au moins élément biréfringent étant un composant distinct du milieu actif.

Dans le premier mode de réalisation, de manière préférentielle, le milieu actif est pompé optiquement par un premier faisceau de pompe présentant une puissance supérieure à 500mW sur une première région et par un deuxième faisceau de pompe présentant une puissance supérieure à 500mW sur une deuxième région distincte de la première région.

De manière encore préférentielle, dans le premier mode de réalisation la première région est séparée de la deuxième région d'une distance inférieure à 1 mm et préférentiellement comprise entre 50 $\mu m$ et 200 $\mu m.$

Dans le premier mode de réalisation, de manière préférentielle, le premier et le deuxième faisceaux de pompe sont obtenus à partir d'un faisceau principal de pompe via une lame séparatrice en intensité insensible à la polarisation.

Selon un deuxième mode de réalisation, ledit milieu actif est un verre dopé présentant une biréfringence telle que ledit au moins élément biréfringent soit formé par ledit verre dopé.

De manière préférentielle, dans le deuxième mode de réalisation, la cavité comprend un élément absorbant non linéaire du faisceau intra-cavité, par exemple un absorbant saturable ou un absorbant à deux photons, adapté pour optimiser une dynamique de bruit de la source laser.

Selon un mode de réalisation de l'invention, le premier et le deuxième matériaux présentent un dopage en oxyde de magnésium.

Selon un mode de réalisation de l'invention, le premier et le deuxième matériaux sont en tantalate de lithium stœchiométrique dopé en oxyde de magnésium.

Selon un mode de réalisation de l'invention, le premier et le deuxième matériaux sont identiques et dans laquelle le premier cristal électro-optique présente une première dimension $l_1$ selon ledit axe optique et le deuxième cristal électro-optique présente une deuxième dimension $l_2$ selon l'axe optique telle que $0.9 \times l_1 \leq l_2 \leq 0.99 \times l_1$ ou $1.01 \times l_1 \leq l_2 \leq 1.1 \times l_1$.

Selon un mode de réalisation de l'invention, la source laser comprend ledit étalon Fabry-Pérot adapté pour que le faisceau laser intra-cavité présente uniquement deux modes longitudinaux, ledit étalon Fabry-Pérot présentant une biréfringence.

Selon un mode de réalisation de l'invention, la source laser ne comprend pas un étalon Fabry-Pérot adapté pour que le faisceau laser intra-cavité présente uniquement deux modes longitudinaux, un premier mode longitudinal à la première fréquence $v_V$ et un deuxième mode longitudinal à la deuxième fréquence $v_H$, et dans laquelle le premier ou le deuxième cristal électro-optique présente une face avec un traitement partiellement réfléchissant de manière à ce que ladite face forme ledit coupleur de sortie.

Selon un mode de réalisation de l'invention, la source laser comprend un premier ensemble d'asservissement relié au premier cristal électro-optique et au deuxième cristal électro-optique et adapté pour effectuer un asservissement de la première fréquence $v_V$ et de la deuxième fréquence $v_H$ indépendamment l'une de l'autre, via une commande de la première tension et de la deuxième tension.

Selon un mode de réalisation de l'invention, ledit coupleur de sortie est monté sur une platine de translation piézoélectrique, ladite source laser comprenant un premier ensemble d'asservissement relié à ladite platine de translation et adapté pour effectuer un asservissement de la première fréquence $v_V$ et de la deuxième fréquence $v_H$ via une commande de la longueur de la cavité, de manière à compenser des dérives long terme du premier mode longitudinal et du deuxième mode longitudinal.

## Brève description des figures :

D'autres caractéristiques, détails et avantages de l'invention ressortiront à la lecture de la description faite en référence aux dessins annexés donnés à titre d'exemple et qui représentent, respectivement :

[Fig.1], une vue schématique d'un laser bi-polarisation et bi-fréquence de l'art antérieur,

[Fig.2A], [Fig.2B], une illustration du phénomène de piégeage cohérent des populations (Coherent Population Trapping) connu de l'art antérieur

[Fig.3], une vue schématique d'un laser bi-polarisation et bi-fréquence selon un mode de réalisation de l'invention,

[Fig.4], une vue schématique d'un laser bi-polarisation et bi-fréquence selon un mode de réalisation de l'invention,

[Fig.5], une vue schématique du premier et du deuxième cristal électro-optique selon un mode de réalisation,

[Fig.6], une vue schématique d'un laser bi-polarisation et bi-fréquence selon un mode de réalisation de l'invention,

[Fig.7], une vue schématique du premier et du deuxième cristal électro-optique assemblés selon un mode de réalisation,

[Fig.8], une vue schématique partielle d'un laser bi-polarisation et bi-fréquence selon un mode de réalisation de l'invention partiellement formé par un demi-VCSEL,

[Fig.9], une vue schématique d'un laser bi-polarisation et bi-fréquence selon un mode de réalisation de l'invention comprenant un premier ensemble d'asservissement

[Fig.10], une vue schématique d'un laser bi-polarisation et bi-fréquence selon un autre mode de réalisation de l'invention comprenant un premier ensemble d'asservissement

Dans les figures, sauf contre-indication, les éléments ne sont pas à l'échelle et les références identiques désignent des éléments identiques.

## Description détaillée :

De manière générale, l'invention porte sur une source laser accordable bi-polarisation et bi-fréquence comprenant deux cristaux électro-optiques chacun muni d'une paire d'électrodes respective afin de contrôler indépendamment la valeur des deux fréquences optiques émises par le laser.

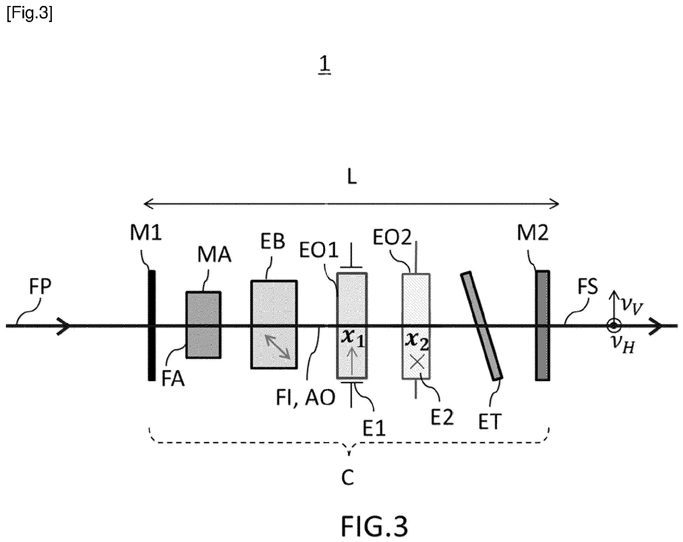

La figure 3 illustre schématiquement une source laser 1 accordable bi-polarisation et bi-fréquence selon un mode de réalisation de l'invention. La source laser 1 comprend une cavité optique C permettant la propagation d'un faisceau laser intra-cavité FI entre un élément hautement réfléchissant M1 et un coupleur de sortie M2. La distance entre l'élément hautement réfléchissant M1 et le coupleur de sortie est appelée longueur de cavité L et l'axe optique du faisceau laser intra-cavité FI est référencé AO sur la figure 3.

Au sein de la cavité laser C, la source laser 1 comprend un milieu actif MA, un élément biréfringent EB, un premier cristal électro-optique EO1, un deuxième cristal électro-optique EO2 et un étalon Fabry-Pérot ET.

La source laser 1 selon l'invention est adaptée pour émettre un faisceau de sortie FS présentant une première fréquence $v_V$ selon une première polarisation linéaire (verticale et perpendiculaire à l'axe optique AO dans l'illustration de la figure 3) et une deuxième fréquence $v_H$ selon une deuxième polarisation linéaire perpendiculaire à la première polarisation linéaire (horizontale et perpendiculaire à l'axe optique AO dans l'illustration de la figure 3).

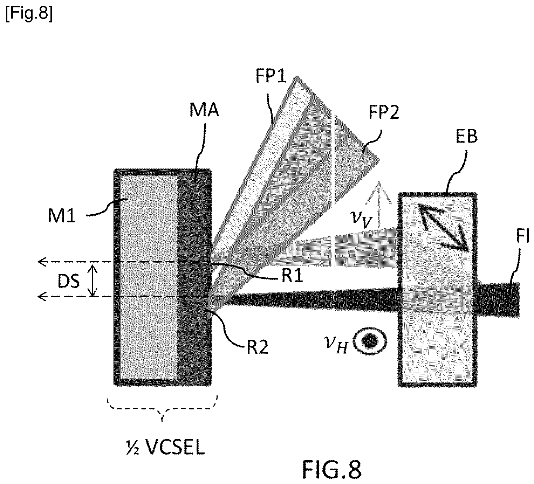

A titre d'exemple, l'élément hautement réfléchissant M1 est un miroir présentant un traitement réfléchissant de manière à présenter un coefficient de réflexion typique de R=99,9% pour la première fréquence $v_V$ et la deuxième fréquence $v_H$. Alternativement, selon un autre mode de réalisation, l'élément optique M1 est formé par le miroir inférieur de Bragg d'un demi-VCSEL (voir figure 8 par exemple).

Le coupleur de sortie M2 est adapté pour transmettre une portion du faisceau laser intra-cavité FI de manière à former le faisceau de sortie FS et pour réfléchir une autre portion du faisceau laser intra-cavité FI au sein de la cavité C. Le coefficient de réflexion du coupleur de sortie M2 aux fréquences optiques $v_V$ et $v_H$ est typiquement compris entre 98% et 99,9%. Sa valeur est fixée en fonction de la valeur du gain optique du milieu actif MA et des pertes de la cavité laser C afin d'assurer un effet laser.

Le milieu actif MA est un élément connu de l'art antérieur et n'est pas spécifique à l'invention. Une description exhaustive des différents modes de réalisation de cet élément sortirait du cadre de l'invention. On se limite ici à préciser qu'il est adapté pour présenter un gain optique à la première fréquence $v_V$ et à la deuxième fréquence $v_H$ lorsqu'il est pompé électriquement ou optiquement de manière à amplifier le faisceau laser intra-cavité FI et assurer un effet laser.

A titre d'exemple non limitatif, dans l'illustration de la figure 3, on a représenté un milieu actif MA pompé optiquement de manière longitudinale par un faisceau de pompe FP laser. Il est entendu que d'autres techniques de pompage connues de l'homme de l'art sont applicables à l'invention.

Comme illustré dans la figure 3, afin de lever la dégénérescence des modes polarisés de la cavité et ainsi de réduire la compétition laser entre ces modes, la cavité C comprend de manière préférentielle un élément biréfringent EB. Autrement dit, l'élément biréfringent EB est adapté pour présenter une biréfringence telle que le faisceau laser intra-cavité FI présente la première fréquence $v_V$ selon la première polarisation linéaire et présente la deuxième fréquence $v_H$ selon la deuxième polarisation linéaire. La direction de chaque polarisation est définie par la direction de l'axe ordinaire et de l'axe extraordinaire de l'élément biréfringent EB.

L'élément biréfringent EB est lui aussi un élément connu de l'art antérieur (voir par exemple figure 1) qui n'est pas spécifique à l'invention. Une description exhaustive des différents modes de réalisation de cet élément sortirait du cadre de l'invention. A titre d'exemple non limitatif, l'élément biréfringent EB est une lame en $YVO_4$ de 2 mm d'épaisseur ou tout autre matériau fortement biréfringent équivalent.

Selon un mode de réalisation différent de celui illustré en figure 3, la levée de dégénérescence des modes polarisés de la cavité n'est pas effectuée par un élément biréfringent EB distinct du milieu actif MA mais par le milieu actif MA lui-même. C'est-à-dire que le milieu actif MA présente une biréfringence suffisamment forte pour que le faisceau laser intra-cavité FI présente la première fréquence $v_V$ selon la première polarisation linéaire et présente la deuxième fréquence $v_H$ selon la deuxième polarisation linéaire.

A titre d'exemple, ce mode de réalisation est possible avec un milieu actif MA qui est un verre dopé. Dans le mode de réalisation dans lequel le milieu actif MA est un verre dopé, de manière préférentielle, le milieu actif MA est pompé optiquement par sa face arrière FA, comme illustré dans la figure 3 afin de rendre la source laser plus compacte. De manière encore préférentielle, pour optimiser la compacité, l'élément optique hautement réfléchissant M1 est formé par un traitement (par exemple dépôt de couches minces) de la face arrière FA.

Dans l'invention, il est nécessaire d'assurer un fonctionnement monomode longitudinal sur chaque état de polarisation de fréquence $v_H$ et $v_V$.

Pour cela, selon une première variante illustrée dans la figure 3, la source laser 1 comprend un étalon Fabry-Perot ET servant de filtre modal intra-cavité et adapté pour que le faisceau laser intra-cavité FI présente uniquement deux modes longitudinaux, un premier mode longitudinal à la première fréquence $v_V$ et un deuxième mode longitudinal à la deuxième fréquence $v_H$.

L'étalon Fabry-Perot ET est lui aussi un élément connu de l'art antérieur (voir par exemple figure 1) qui n'est pas spécifique à l'invention. Une description exhaustive des différents modes de réalisation de cet élément sortirait du cadre de l'invention. On se limitera à préciser ici qu'il faut que la largeur du pic de transmission de l'étalon ET soit faible pour réduire le nombre de modes laser en compétition. De plus, il est nécessaire que son intervalle spectral libre soit suffisamment grand pour qu'un seul mode longitudinal pour chaque polarisation puisse être sélectionné, pour avoir un unique pic de transmission de l'étalon ET couvert par le spectre du gain du milieu actif MA.

A titre d'exemple, l'étalon Fabry-Perot ET est une lame à faces planes et parallèles en silice ou en YAG ou encore en $YVO_4$ et présente une épaisseur typiquement comprise entre 50 et 200 $\mu m$.

De manière préférentielle, l'étalon Fabry-Pérot ET présente une biréfringence (e.g. en $YVO_4$). En effet, un étalon ET biréfringent permet d'introduire une différence d'épaisseur et donc d'intervalle spectral libre causée par la biréfringence de l'étalon, qui se traduit par un décalage spectral entre le maximum de transmission de l'étalon pour la polarisation ordinaire et celui de la polarisation extraordinaire. La sélection des modes longitudinaux n'est donc pas identique pour les deux polarisations. Cela permet obtenir des différences de fréquence élevées, c'est-à-dire proches ou supérieures à l'intervalle spectral libre de la cavité. L'étalon permet de déplacer le point de fonctionnement naturel du laser bi-fréquence à une valeur de différence de fréquence non nulle, dépendant uniquement de la biréfringence de l'étalon. Contrairement au cas d'un étalon isotrope, il est possible ajuster l'inclinaison de l'étalon pour sélectionner une zone d'accordabilité de la différence de fréquence.

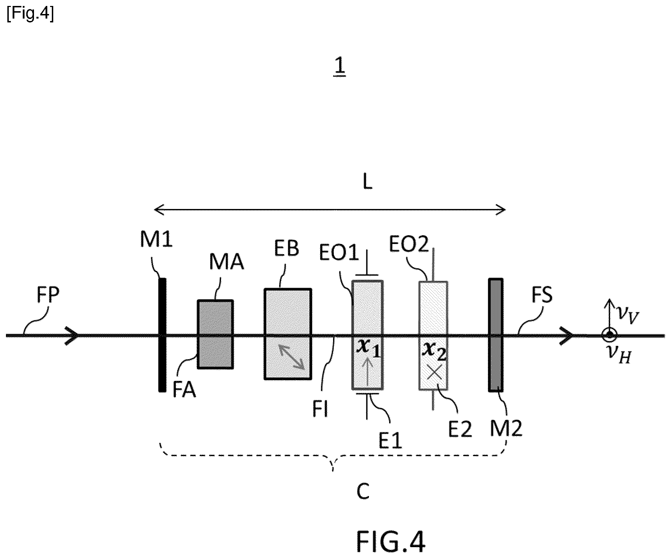

Selon une deuxième variante illustrée dans la figure 4, la source laser 1 ne comprend pas d'étalon Fabry-Perot ET pour réaliser le filtrage modal intra-cavité. Dans cette deuxième variante, c'est la cavité laser C elle-même qui, par le réglage de sa longueur L, est adaptée pour assurer une émission monomode longitudinale pour chaque polarisation. En effet, en agençant les différents éléments de la cavité laser de manière adaptée, il est possible de suffisamment réduire la taille de la cavité de manière à ce qu'elle présente un intervalle spectral libre suffisamment grand pour avoir un unique pic de transmission couvert par le spectre du gain du milieu actif MA. Pour rappel, l'intervalle spectral libre de la cavité vaut

$$ISL = \frac{c}{2L}$$ et les intervalles spectraux libres des modes polarisés horizontalement et verticalement peuvent être considérés comme égaux au premier ordre

A titre d'exemple non limitatif, pour un milieu actif présentant un gain sur une gamme spectrale typique de 100 GHz, une cavité laser C de longueur $L \leq 2$ mm présente un intervalle spectral libre suffisamment grand pour permettre la sélection d'un unique mode longitudinal pour chaque polarisation.

En outre, la cavité laser C comprend le premier cristal électro-optique EO1 réalisé dans un premier matériau et le deuxième cristal électro-optique EO2 dans réalisé un deuxième matériau.

Plus précisément, le premier cristal électro-optique EO1 présente un premier axe optique $x_1$ avec une même direction que la première polarisation linéaire (verticale dans la figure 3). De plus, le premier cristal électro-optique EO1 est muni d'une première paire d'électrodes E1 adaptée pour appliquer au sein du cristal une première tension $V_1$ selon la direction de la première polarisation linéaire.

Le deuxième cristal électro-optique EO2 présente un deuxième axe optique $x_2$ avec une même direction que la deuxième polarisation linéaire (horizontale dans la figure 3). De plus, il comprend une deuxième paire d'électrodes E2 adaptée pour appliquer au sein du deuxième cristal électro-optique une deuxième tension $V_2$ selon la direction de la deuxième polarisation linéaire. De manière préférentielle, dans le mode de l'invention illustré par la figure 4 dans lequel le laser 1 ne comprend pas un étalon ET, le deuxième cristal électro-optique EO2 présente une face avec un traitement partiellement réfléchissant de manière à ce que la face traitée forme le coupleur de sortie MS.

Par l'agencement précité, les cristaux EO1 et EO2 permettent un contrôle indépendant de la valeur des deux fréquences optiques $v_H$ et $v_V$ émises par le laser. En effet, pour un premier matériau et un deuxième matériau adaptés, il existe une première et une deuxième tension $V_1, V_2$ adaptées pour contrôler indépendamment une valeur de la première fréquence $v_V$ et une valeur de la deuxième fréquence $v_H$ présentes dans le faisceau de sortie FS.

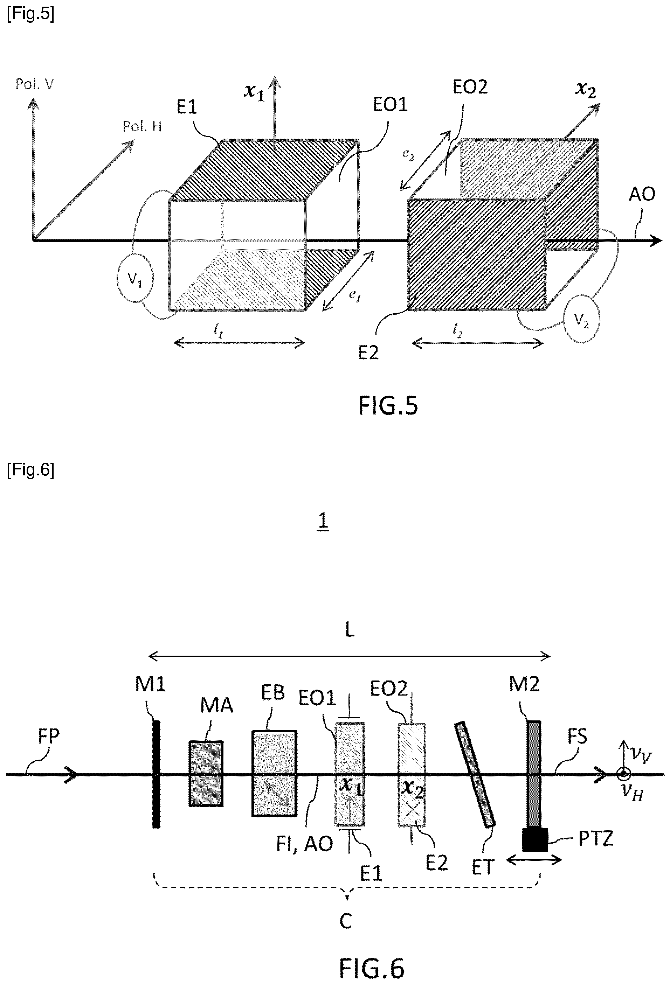

Ce résultat est démontré ci-dessous pour le cas particulier de cristaux électro-optiques en MgO:SLT mais le principe peut être étendu à d'autres cristaux. La figure 5 illustre les paramètres des cristaux EO1 et EO2 utilisés pour démontrer le résultat précité.

Pour le calcul, on considère que les cristaux EO1 et EO2 sont insérés dans une cavité C de la source laser 1 selon le mode de réalisation de la figure 6. Dans ce mode de réalisation, le coupleur de sortie M2 est monté sur un transducteur piézo-électrique (ou platine de translation piézoélectrique PTZ) qui permet d'ajuster la longueur L de la cavité optique C. La fréquence absolue de chacun des deux modes ainsi que la différence de fréquence entre eux peut être ajustée en commandant une translation du coupleur de sortie monté sur le transducteur piézoélectrique PZT.

En notant $\eta_P$ le coefficient piézo-électrique du transducteur piézo-électrique PZT, l'application d'une tension $V_P$ permet de translater le coupleur de sortie M2 d'une quantité $\eta_P \times V_P$, ce qui permet de contrôler la longueur de la cavité et de modifier les fréquences optiques des deux modes de polarisation qui oscillent, et de façon égale au premier ordre. Ce réglage présente l'intérêt de pouvoir modifier simultanément les fréquences absolues des deux modes de polarisation

suivant l'expression : $\Delta v_V = 2 \frac{\eta_P V_P}{\lambda} ISL_V$ avec au premier ordre $ISL_V = ISL_H = \frac{c}{2 L_{cav}}$
$\Delta v_H = 2 \frac{\eta_P V_P}{\lambda} ISL_H$

Comme illustré dans la figure 5, le premier cristal EO1 présente une longueur $l_1$ (dimension selon l'axe optique AO) et une épaisseur $e_1$ (dimension perpendiculaire à l'axe optique AO entre la paire d'électrode E1). Le deuxième cristal EO2 présente une longueur $l_2$ et une épaisseur $e_2$ (dimension perpendiculaire à l'axe optique AO entre la paire d'électrode E2). Les tensions $V_1, V_2$ sont appliquées entre les faces perpendiculaires à l'axe optique $x_1, x_2$ de chaque cristal (les faces perpendiculaires à l'axe optique de chaque cristal servent d'électrodes).

De manière connue en soit, l'application d'une tension entre les deux faces opposées d'un seul cristal permet de générer une variation d'indice qui est différente entre les deux modes de polarisation de la cavité. Le contrôle de cette tension permet de changer la différence de fréquence entre les modes, mais modifie également les deux fréquences absolues.

L'équation de l'ellipsoïde des indices dans un des deux cristaux électro-optiques peut s'écrire :

$$\left(\frac{1}{n^2}\right)_1 x^2 + \left(\frac{1}{n^2}\right)_2 y^2 + \left(\frac{1}{n^2}\right)_3 z^2 + 2\left(\frac{1}{n^2}\right)_4 yz + 2\left(\frac{1}{n^2}\right)_5 zx + 2\left(\frac{1}{n^2}\right)_6 xy = 1.$$

Selon un mode de réalisation, le premier et le deuxième matériau électro-optique est identique et est du LN (niobate de lithium), SLN (niobate de lithium stœchiométrique), MgO:SLN (niobate de lithium stœchiométrique dopé avec de l'oxyde de magnesium), LT (tantalate de lithium), SLT (tantalate de lithium stœchiométrique), MgO:SLT (tantalate de lithium stœchiométrique dopé avec de l'oxyde de magnesium), la présence d'un champ électrostatique **E** ($E_x$, $E_y$, $E_z$),

conduit à modifier les coefficients $\left(\frac{1}{n^2}\right)_i$ suivant l'expression :

$$\begin{bmatrix} \Delta\left(\frac{1}{n^2}\right)_1 \\ \Delta\left(\frac{1}{n^2}\right)_2 \\ \Delta\left(\frac{1}{n^2}\right)_3 \\ \Delta\left(\frac{1}{n^2}\right)_4 \\ \Delta\left(\frac{1}{n^2}\right)_5 \\ \Delta\left(\frac{1}{n^2}\right)_6 \end{bmatrix} = \begin{bmatrix} 0 & r_{12}=-r_{22} & r_{13} \\ 0 & r_{22} & r_{23}=r_{13} \\ 0 & 0 & r_{33} \\ 0 & r_{42} & 0 \\ r_{51}=r_{42} & 0 & 0 \\ r_{61}=-r_{22} & 0 & 0 \end{bmatrix} \begin{bmatrix} E_x \\ E_y \\ E_z \end{bmatrix}.$$

Dans le cas particulier du tantalate de lithium et de tous ses dérivés, les valeurs disponibles dans la littérature permettent de réécrire l'expression :

$$\begin{bmatrix} \Delta\left(\frac{1}{n^2}\right)_1 \\ \Delta\left(\frac{1}{n^2}\right)_2 \\ \Delta\left(\frac{1}{n^2}\right)_3 \\ \Delta\left(\frac{1}{n^2}\right)_4 \\ \Delta\left(\frac{1}{n^2}\right)_5 \\ \Delta\left(\frac{1}{n^2}\right)_6 \end{bmatrix} = \begin{bmatrix} 0 & -3,4.\,10^{-12} & 6,96.\,10^{-12} \\ 0 & 3,4.\,10^{-12} & 6,96.\,10^{-12} \\ 0 & 0 & 29,6.\,10^{-12} \\ 0 & 28.\,10^{-12} & 0 \\ 28.\,10^{-12} & 0 & 0 \\ -3,4.\,10^{-12} & 0 & 0 \end{bmatrix} \begin{bmatrix} E_x \\ E_y \\ E_z \end{bmatrix}.$$

En considérant seulement le premier cristal EO1 de longueur $l_1$, l'application d'une tension $V_1$ suivant l'axe optique $x_1$ et sur une épaisseur $e_1$, génère un champ électrostatique $E_1 = \frac{V_1}{e_1}$ qui permet de produire pour les ondes polarisées verticalement et horizontalement un déphasage :

$$\Delta\varphi_V^{cristal\ 1} = \frac{1}{2}n_z^3\, r_{33}\,\frac{l_1}{\lambda}\,2\pi\,\frac{V_1}{e_1}$$

$$\Delta\varphi_H^{cristal\ 1} = \frac{1}{2}n_x^3\, r_{13}\,\frac{l_1}{\lambda}\,2\pi\,\frac{V_1}{e_1}$$

avec $n_z$, $n_x$ les indices vus respectivement par les modes polarisés verticalement et horizontalement, et qui correspondent respectivement aux indices ordinaires et extraordinaires.

Si deux cristaux sont employés suivant la configuration de la figure 5, le second cristal ayant une longueur $l_2$, auquel est appliqué une tension $V_2$ suivant l'axe optique $x_2$ et sur une épaisseur $e_2$, en faisant l'approximation $\lambda_V = \lambda_H = \lambda$, le déphasage total produit sur les ondes polarisées verticalement et horizontalement peut s'écrire :

$$\Delta\varphi_V^{cristaux\ 1+2} = \frac{1}{2}n_z^3\, r_{33}\,\frac{l_1}{\lambda}\,2\pi\,\frac{V_1}{e_1} + \frac{1}{2}n_x^3\, r_{13}\,\frac{l_1}{\lambda}\,2\pi\,\frac{V_2}{e_2}$$

$$\Delta\varphi_H^{cristaux\ 1+2} = \frac{1}{2}n_x^3\, r_{13}\,\frac{l_1}{\lambda}\,2\pi\,\frac{V_1}{e_1} + \frac{1}{2}n_z^3\, r_{33}\,\frac{l_2}{\lambda}\,2\pi\,\frac{V_2}{e_2}.$$

La variation des fréquences optiques obtenue peut s'exprimer : $\quad \Delta\nu_V = \frac{2\Delta\varphi_V}{2\pi}\,ISL_V \quad$ en notant $ISL_{V,H}$
$$\Delta\nu_H = \frac{2\Delta\varphi_H}{2\pi}\,ISL_H$$

l'intervalle spectral libre de la cavité respectivement du mode de polarisation verticale et horizontale, que l'on peut considérer au premier ordre comme égaux et notés simplement ISL.

Les fréquences optiques des modes de polarisation verticale et horizontale peuvent être décomposées au premier ordre selon :
$$\nu_V(V_P, V_1, V_2) = \nu_V(0,0,0) + \Delta\nu_V(V_P, V_1, V_2)$$
$$\nu_H(V_P, V_1, V_2) = \nu_H(0,0,0) + \Delta\nu_H(V_P, V_1, V_2)$$
, avec

$$\Delta\nu_V(V_P, V_1, V_2) = ISL\left[2\frac{\eta_P V_P}{\lambda} + \frac{1}{\pi}\left[\frac{1}{2}n_z^3\, r_{33}\,\frac{l_1}{\lambda}\,2\pi\,\frac{V_1}{e_1} + \frac{1}{2}n_x^3\, r_{13}\,\frac{l_2}{\lambda}\,2\pi\,\frac{V_2}{e_2}\right]\right]$$

$$\Delta \nu_H(V_P, V_1, V_2) = ISL\left[2\frac{\eta_P V_P}{\lambda} + \frac{1}{\pi}\left[\frac{1}{2}n_x^3\, r_{13}\frac{l_1}{\lambda}2\pi\frac{V_1}{e_1} + \frac{1}{2}n_z^3\, r_{33}\frac{l_2}{\lambda}2\pi\frac{V_2}{e_2}\right]\right]'$$

soit

$$\Delta \nu_V(V_P, V_1, V_2) = \frac{ISL}{\lambda}\left[2\eta_P V_P + n_z^3\, r_{33}\frac{l_1}{e_1}V_1 + n_x^3\, r_{13}\frac{l_2}{e_2}V_2\right]$$

$$\Delta \nu_H(V_P, V_1, V_2) = \frac{ISL}{\lambda}\left[2\eta_P V_P + n_x^3\, r_{13}\frac{l_1}{e_1}V_1 + n_z^3\, r_{33}\frac{l_2}{e_2}V_2\right]$$

En limitant l'étude à l'impact des tensions $V_1$ et $V_2$, le système s'exprime de façon simplifiée (Système d'équations 1):

$$\Delta \nu_V(V_1, V_2) = aV_1 + bV_2$$

$$\Delta \nu_H(V_1, V_2) = cV_1 + dV_2$$

Avec

$$a = \frac{c}{2L_{cav}\,\lambda}n_z^3\, r_{33}\frac{l_1}{e_1},\ b = \frac{c}{2L_{cav}\,\lambda}n_x^3\, r_{13}\frac{l_2}{e_2},\ c = \frac{c}{2L_{cav}\,\lambda}n_x^3\, r_{13}\frac{l_1}{e_1},\ d = \frac{c}{2L_{cav}\,\lambda}n_z^3\, r_{33}\frac{l_2}{e_2}.$$

Selon l'invention, il est nécessaire que le premier et le deuxième matériau électro-optique présentent une matrice de coefficients $\left(\frac{1}{n^2}\right)_i$ tels que le Système d'équations $1$ $\begin{cases} aV_1 + bV_2 = \Delta \nu_V \\ cV_1 + dV_2 = \Delta \nu_H \end{cases}$ présente un discriminant

$$\Delta = \left(\frac{c}{2L_{cav}\,\lambda}\right)^2\frac{l_1 l_2}{e_1 e_2}\left[(n_z^3\, r_{33})^2 - (n_x^3\, r_{13})^2\right] > 0.$$

Ce système d'équations 1 est donc résoluble et l'on peut calculer les coefficients $\alpha, \beta, \gamma, \delta$ inverses tels que $\begin{cases} V_1 = \alpha \Delta \nu_V + \beta \Delta \nu_H \\ V_2 = \gamma \Delta \nu_V + \delta \Delta \nu_H \end{cases}$ pour réécrire :

$$\Delta \nu_V(V_V) = \frac{ISL}{\lambda}\kappa V_V$$

$$\Delta \nu_H(V_H) = \frac{ISL}{\lambda}\kappa V_H$$

Le système de deux cristaux électro-optiques EO1 et EO2 dont les axes optiques sont orientés perpendiculairement permet donc de piloter indépendamment la fréquence optique de chaque mode si les tensions de commandes $V_1$ et $V_2$ sont construites à partir de combinaisons linéaires des fréquences optiques $\nu_V$ et $\nu_H$.

Selon un mode de réalisation particulier, la cavité laser C présente une longueur L=25 mm et comprend un élément biréfringent EB en $YVO_4$ de longueur 2 mm ainsi que deux cristaux EO1 et EO2 en MgO:SLT de longueurs $l_1 = l_2 = 1$ mm. L'intervalle spectral libre de la cavité laser C vaut 5,1 GHz.

Avec deux électro-optiques d'épaisseurs $e_1 = e_2 = 2$ mm, le système d'équations 1 devient :

$$\Delta \nu_V(V_1, V_2) = 0{,}872.V_1 + 0{,}204.V_2\ (MHz/V)$$

$$\Delta v_H(V_1, V_2) = 0{,}204 . V_1 + 0{,}872 . V_2 \ (MHz/V)$$

Ce qui implique :

$$\Delta v_V(V_1, V_2) = 0{,}872 . V_1 + 0{,}204 . V_2 \ (MHz/V)$$

$$\Delta v_H - \Delta v_V(V_1, V_2) = -0{,}668 . V_1 + 0{,}668 . V_2 \ (MHz/V)$$

Ainsi, si on dispose des signaux $\varepsilon_V$ et $\varepsilon_H$ pour corriger respectivement les fréquences optiques de modes polarisés respectivement verticalement et horizontalement, il est possible de créer une tension de commande par combinaison linéaire avec :

$$V_1 = 1{,}2132 . \epsilon_V - 0{,}2838 . \epsilon_H \ (V)$$

$$V_2 = -0{,}2838 . \epsilon_V + 1{,}2132 . \epsilon_H \ (V)$$

Dans une autre configuration, si on dispose des signaux $\varepsilon_V$ pour corriger la fréquence optique du mode de polarisation verticale et $\varepsilon_{H\text{-}V}$ pour corriger la différence de fréquence entre les deux modes, il est possible de créer une tension de commande par combinaison linéaire avec :

$$V_1 = 0{,}9294 . \epsilon_V - 0{,}2838 . \epsilon_{H-V} \ (V)$$

$$V_2 = 0{,}9294 . \epsilon_V + 1{,}2132 . \epsilon_{H-V} \ (V)$$

La démonstration précédente a été présentée avec des cristaux EO1 et EO2 dans un matériau identique. De manière plus générale il est possible d'obtenir un contrôle indépendant de la valeur des deux fréquences optiques $v_H$ et $v_V$ émises par le laser même si le premier matériau et le deuxième matériau sont différents.

Pour tout premier et deuxième matériau biréfringent, on peut définir le système d'équation 1 suivant, obtenu pour une première tension $V_1$ et pour une deuxième tension $V_2$ produisant une variation $\Delta v_V(V_1, V_2)$ de la première fréquence $v_V$ et produisant une variation $\Delta v_H(V_1, V_2)$ de la deuxième fréquence $v_H$ :

$$\begin{cases} \Delta v_V(V_1, V_2) = aV_1 + bV_2 \\ \Delta v_H(V_1, V_2) = cV_1 + dV_2 \end{cases}$$

avec a et c des coefficients dépendant de la susceptibilité électrique du premier matériau et avec b et d des coefficients dépendant de la susceptibilité électrique du deuxième matériau.

Afin de garantir qu'il existe un couple de tensions $V_1$ et $V_2$ permettant le contrôle indépendant de la valeur des deux fréquences optiques $v_H$ et $v_V$, selon l'invention, le premier matériau et le deuxième matériau sont tels qu'un discriminant du système d'équation 1 est supérieur à 0.

En résumé, par une disposition judicieuse des cristaux EO1 et EO2, l'invention permet de surmonter un défaut majeur des lasers bi-fréquence et bi-polarisation de l'art antérieur en contrôlant indépendamment une valeur de chacune des deux fréquences optiques émises par le laser.

Selon un mode de réalisation préféré de l'invention, le premier matériau et le deuxième matériau présentent un dopage en oxyde de magnésium. Cela permet de réduire l'effet photoréfractif et donc permet de minimiser les pertes de la cavité C. De manière encore préférentielle, le premier et le deuxième matériau sont en tantalate de lithium stœchiométrique dopé en oxyde de magnésium ou en niobate de lithium stœchiométrique dopé en oxyde de magnésium qui présentent des pertes faibles aux longueurs d'onde typiques des sources laser ½ VCSEL bi fréquence bi-polarisation. Le tantalate de lithium stœchiométrique dopé en oxyde de magnésium est optimal car il présente un minimum de perte aux longueurs d'onde typiques des sources laser ½ VSCEL bi fréquence bi-polarisation (ex : 852 nm).

De manière préférentielle, la source laser 1 comprend un élément de régulation thermique (non représenté sur les figures) pour réguler la température des deux cristaux EO1 et EO2. Ainsi, il est possible de réduire les dérives de température des cristaux EO1 et EO2, ces derniers étant très sensibles à l'effet thermo-optique : leurs indices (ordinaire et extraordinaire) varient très rapidement avec la température.

Afin de minimiser les dérives du laser provoquées par l'effet thermo-optique dans les cristaux EO1 et EO2, de manière préférentielle le premier et le deuxième matériau sont identiques et le premier cristal électro-optique présente une première longueur $l_1$ et le deuxième cristal électro-optique présente une deuxième longueur $l_2$ telle que $0.9 \times l_1 \le l_2 \le 0.99 \times l_1$ ou $1.01 \times l_1 \le l_2 \le 1.1 \times l_1$. Pour clarifier, par « longueur » du cristal, on entend ici la dimension traversée par le faisceau laser intra-cavité FI.

Ainsi, l'un des modes de polarisation de la cavité voit l'indice ordinaire du premier cristal puis la réfraction extraordinaire du second. L'autre mode subit la réfraction extraordinaire du premier cristal puis est affecté par l'indice ordinaire du second. Comme les deux cristaux EO1 et EO2 ont quasiment la même longueur, les intervalles spectraux libres des deux modes sont très proches. Une petite variation de température fait varier leurs intervalles spectraux mais de façon quasiment égale et la différence de fréquence optique des modes ne varie que faiblement.

Les inventeurs ont déterminé qu'une différence de longueur inférieure ou égale à 10% entre les deux cristaux EO1 et EO2 était nécessaire pour réduire efficacement l'effet thermo-optique. De plus, il est préférable que la longueur des cristaux EO1 et EO2 diffère de plus de 1% pour permettre une certaine accordabilité sur les modes générés. Ainsi, on s'assure qu'il existe un point de fonctionnement du laser pour une plage de température d'utilisation conventionnelle.

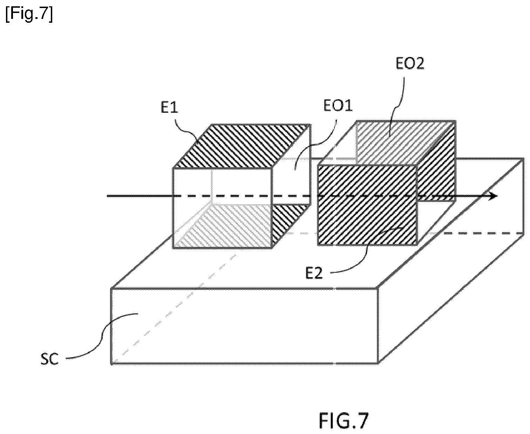

La figure 7 illustre un mode de réalisation de l'invention dans lequel les cristaux EO1 et EO2 sont assemblés sur un support commun SC. Le support commun SC permet ainsi un assemblage plus facile du laser de l'invention, avec une robustesse améliorée. Selon un mode de réalisation, les cristaux EO1 et EO2 sont maintenus sur le support commun SC par collage. Alternativement, le support commun est un gabarit comprenant des rainures (non représentées) de dimensions adaptées pour permettre le maintien mécanique des cristaux EO1 et EO2 lorsque ces derniers sont disposés dans leur rainure respective.

Selon un mode de réalisation, le support commun SC est réalisé dans un matériau isolant électriquement pour ne pas perturber l'application du champ électrique dans les cristaux EO1 et EO2.

Selon un mode de réalisation, le support commun SC permet un assemblage de tous les éléments optiques de la cavité C, à l'exception de l'étalon ET. Cela permet de faciliter l'assemblage du laser de l'invention en améliorant sa robustesse. L'étalon ET n'est pas assemblé sur le support commun SC afin de permettre son réglage en orientation ou translation.

Alternativement, selon un mode de réalisation différent de celui illustré dans la figure 7, les cristaux EO1 et EO2 sont assemblés par « *stacking »* et sont accolés à une couche diélectrique commune de manière à former un empilement.

Selon un premier mode de réalisation, le milieu actif MA est un milieu à gain homogène (comme une région active semi-conductrice). Dans ce premier mode de réalisation, il est nécessaire que l'élément biréfringent EB permette de séparer spatialement au moins partiellement les deux modes de polarisations perpendiculaires et croisés dans le milieu actif. Ainsi, chaque mode interagit en partie avec sa propre zone de gain et ne rentre pas en compétition avec son voisin.

De manière préférentielle, dans ce premier mode de réalisation, l'axe optique de l'élément biréfringent EB est orienté de façon à maximiser la séparation spatiale entre le faisceau dénommé « ordinaire » (correspondant à $v_H$ sur les figures 3, 4, 6 avec polarisation dans un plan perpendiculaire à l'axe optique de l'élément biréfringent EB) et le faisceau dénommé « extraordinaire » (correspondant à $v_V$ sur les figures 3, 4, 6, avec polarisation dans le plan de l'axe optique). Selon le mode de réalisation le plus simple à mettre en œuvre, comme illustré dans les figures 3, 4, 6, l'élément biréfringent EB présente un axe optique incliné de 45° par rapport à l'axe optique AO du faisceau laser intra cavité. Ainsi, la moitié du faisceau laser intra-cavité FI est projetée sur l'axe ordinaire et n'est pas déviée par la traversée de l'élément biréfringent EB alors que la partie projetée sur l'axe extraordinaire est déviée d'une quantité qui dépend de l'épaisseur du l'élément biréfringent EB et de sa biréfringence.

La figure 8 illustre schématiquement une partie d'une source laser 1 selon le premier mode de réalisation de l'invention dans lequel le milieu actif MA et l'élément hautement réfléchissant M1 sont formés par un demi-VCSEL. Plus précisément, dans le mode de réalisation de la figure 8, c'est la région semi conductrice à gain du demi-VCSEL qui forme le milieu actif MA. De plus, le miroir inférieur de Bragg du demi-VCSEL forme l'élément hautement réfléchissant M1.

On rappelle ici qu'un demi-VCSEL est formé en retirant les couches disposées au-dessus du milieu actif (ex : le miroir de Bragg supérieur et le contact métallique) d'un VCSEL conventionnel.

Dans le mode de réalisation de la figure 8, le milieu actif est un milieu homogène. Il est donc nécessaire que la cavité C comprenne un élément biréfringent EB (qui est un composant distinct du milieu actif) pour séparer spatialement au moins partiellement les deux modes de polarisation perpendiculaires et croisés dans le milieu actif et ainsi assurer que chaque mode dispose d'une certaine zone de gain qui lui est propre et ne rentre pas en compétition avec son voisin. Dans l'illustration de la figure 8, à titre d'exemple non limitatif, l'élément biréfringent EB permet de séparer complètement les deux modes de polarisations dans le milieu actif. Ainsi, le mode de polarisation $v_V$ interagit uniquement avec la première région R1 du milieu actif MA qui est pompée par un premier faisceau de pompe FP1. De même, le mode de polarisation $v_H$ interagit uniquement avec la deuxième région R2 du milieu actif MA qui est pompée par un deuxième faisceau de pompe FP2.

Selon un mode de réalisation préféré, la première région R1 est séparée de la deuxième région R2 d'une distance DS inférieure à 1 mm afin de limiter la longueur de l'élément biréfringent EB. En effet, il existe approximativement un facteur 10 entre une distance DS de séparation prédéterminée et la longueur de l'élément biréfringent EB nécessaire pour obtenir cette distance DS de séparation. Or, une longueur de l'élément biréfringent EB trop importante augmentera inutilement les pertes de la cavité laser C, ce qui peut rendre complexe l'obtention de l'effet laser. Les inventeurs ont déterminé qu'une distance DS comprise entre 50 $\mu$m et 200 $\mu$m était optimale pour éviter une compétition entre les deux modes de polarisation tout en limitant la longueur de l'élément biréfringent EB (et donc les pertes optiques associées à cet élément).

De manière préférentielle, chacun des faisceaux de pompe FP1, FP2 présente une puissance supérieure à 500mW (et préférentiellement supérieure à 750 mW) avant sa traversée de la région R1, R2 respectivement afin d'assurer un gain suffisant dans le milieu actif MA.

Afin d'optimiser la dynamique de bruit du laser du mode de réalisation de la figure 8, il est préférable que le premier et le deuxième faisceaux de pompe FP1, FP2 soient obtenus à partir d'un faisceau principal de pompe via une lame séparatrice en intensité (non représentée) insensible à la polarisation. Ainsi, on minimise le transfert de bruit entre les faisceaux de pompe FP1, FP2 et les modes de cavités du laser. Plus généralement, pour minimiser ce transfert de bruit, il est préférable que le bruit d'intensité relatif du premier faisceau de pompe FP1 et le bruit d'intensité relatif du deuxième faisceau de pompe FP2 soient corrélés et en phase.

Selon un deuxième mode de réalisation, le milieu actif MA est un milieu à gain inhomogène (comme un verre dopé). Dans ce deuxième mode de réalisation, il n'est pas nécessaire de séparer spatialement les deux modes polarisés dans la cavité via la biréfringence des éléments de la cavité (le milieu actif MA et/ou l'élément biréfringent EB) qui peuvent se co-propager dans le milieu actif et plus généralement dans la cavité laser.

De manière préférentielle, dans le mode de réalisation où le milieu actif MA est un verre dopé, la cavité laser C comprend un élément absorbant non linéaire du faisceau intra-cavité, par exemple un absorbant saturable ou un absorbant à deux photons, de manière à optimiser une dynamique de bruit de la source laser. Cet élément est connu de l'art antérieur (voir par exemple A. El Amili et M. Alouini. "Experimental evidence and theoretical modeling of two-photon absorption dynamics in the reduction of intensity noise of solid-state Er:Yb lasers", Opt. lett, vol. 21, no. 7, pages 1926, 2013.). Dans ce mode de réalisation, de manière préférentielle, la levée de dégénérescence des modes polarisés de la cavité est effectuée par la biréfringence du verre dopé lui-même. Ainsi, il n'est pas nécessaire d'inclure un élément biréfringent EB distinct du milieu actif MA.

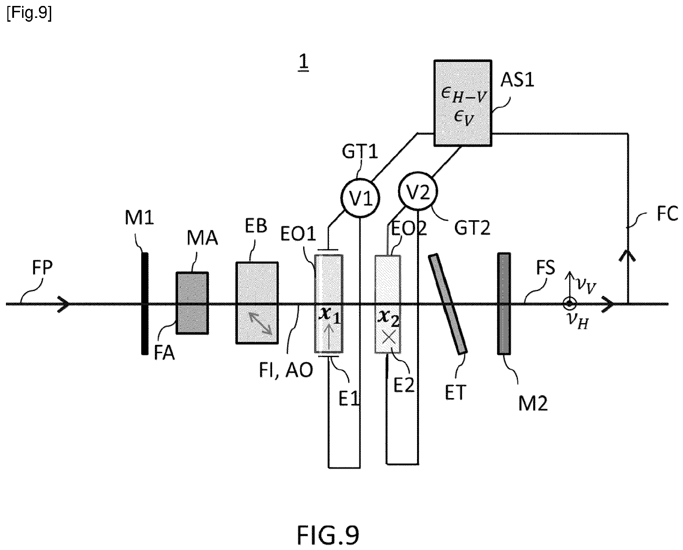

La figure 9 illustre un mode de réalisation de l'invention dans lequel la source laser 1 est asservie en fréquence pour les deux modes de polarisation $v_V$ et $v_H$. Pour cela, la source laser de la figure 9 comprend un premier générateur de tension GT1 et un deuxième générateur de tension GT2 respectivement adaptés pour appliquer les tensions $V_1$ et $V_2$ dans les cristaux EO1 et EO2. Les générateurs de tension GT1 et GT2 sont pilotés par un premier ensemble d'asservissement AS1. Ce premier ensemble d'asservissement AS1 est un montage électronique de contrôle conventionnel (circuit électronique d'un régulateur PID, PC, etc...) qui permet d'asservir deux signaux de correction $\varepsilon_V$ et $\varepsilon_{H-V}$ générés à partir de l'interrogation d'une portion FC du faisceau de sortie FS sur deux références externes, par exemple des transitions atomiques (non représentées). Un premier signal de correction $\varepsilon_V$ permet de corriger la fréquence optique du mode de polarisation verticale $v_V$ et un deuxième signal de correction $\varepsilon_{H-V}$ permet de corriger la fréquence du battement entre les deux modes $v_H - v_V$.

Comme évoqué précédemment, la disposition particulière des cristaux EO1 et EO2 permet d'asservir indépendamment la fréquence optique du mode de polarisation verticale $v_V$ et la fréquence du battement entre les deux modes $v_H - v_V$. La génération des tensions de commande correspondantes $V_1$ et $V_2$ dans les cristaux électro-optiques EO1 et EO2 à partir des signaux de correction $\varepsilon_V$ et $\varepsilon_{H-V}$ n'est pas spécifique à l'invention et peut être réalisée par tout montage électronique connu de l'homme de l'art.

Alternativement, le premier ensemble d'asservissement AS1 permet d'asservir deux signaux de correction $\varepsilon_V$ et $\varepsilon_H$ générés à partir de l'interrogation de la portion FC du faisceau de sortie FS sur deux références externes. Le deuxième signal de correction $\varepsilon_H$ permet de corriger la fréquence optique du mode de polarisation horizontal $v_H$.

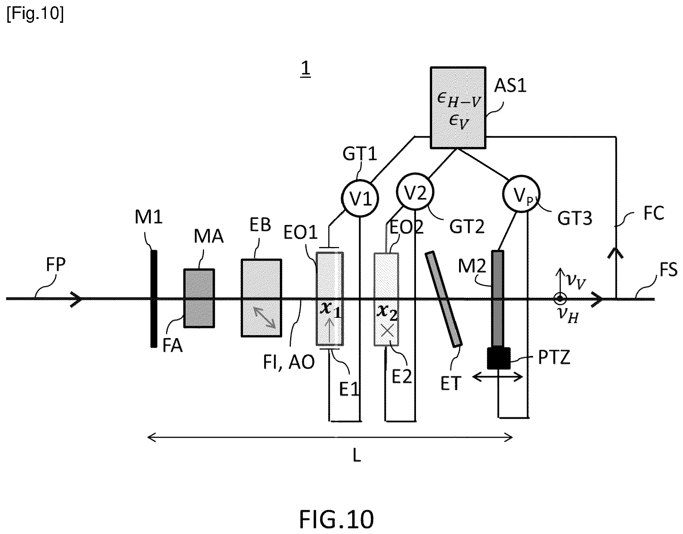

La figure 10 illustre une variante du mode de réalisation de la figure 9, dans laquelle il est possible d'effectuer un asservissement de la première fréquence $v_V$ et de la deuxième fréquence $v_H$ via une commande de la longueur L de la cavité, de manière à compenser des dérives long terme du premier mode longitudinal et du deuxième mode longitudinal. Selon cette variante, le coupleur de sortie M2 est monté sur une platine de translation piézoélectrique PTZ. En outre, le premier ensemble d'asservissement AS1 est adapté pour piloter un troisième générateur de tension GT3 adapté pour appliquer une tension $V_P$ dans la platine de translation piézoélectrique PTZ afin de translater le coupleur de sortie M2. Par un asservissement du signal de correction $\varepsilon_V$ par exemple, il est possible de compenser des dérives long terme du premier mode longitudinal et du deuxième mode longitudinal (correction au kHz). A contrario, les fluctuations court terme des fréquences $v_V$ et $v_H$ sont corrigées par les cristaux EO1 et EO2 (via les générateurs de tension GT1 et GT2) qui permettent une correction au MHz.

**Revendications**

1. Source laser (1) accordable bi-polarisation et bi-fréquence adaptée pour émettre un faisceau de sortie (FS) présentant une première fréquence $\nu_V$ selon une première polarisation linéaire et une deuxième fréquence $\nu_H$ selon une deuxième polarisation linéaire perpendiculaire à la première polarisation linéaire, la source laser comprenant une cavité optique (C) adaptée pour propager un faisceau laser intra-cavité (FI) entre :

   - un élément hautement réfléchissant (M1) à la première fréquence $\nu_V$ et à la deuxième fréquence $\nu_H$, et
   - un coupleur de sortie (M2) adapté pour transmettre une portion du faisceau laser intra-cavité (FI) de manière à former le faisceau de sortie et pour réfléchir une autre portion du faisceau laser intra-cavité (FI), une distance (L) entre l'élément hautement réfléchissant (M1) et le coupleur de sortie étant appelée longueur de cavité,

   la cavité optique (C) comprenant les éléments suivants disposés entre l'élément hautement réfléchissant (M1) et le coupleur de sortie (M2) :

   - un milieu actif (MA) adapté pour présenter un gain optique à la première fréquence $\nu_V$ et à la deuxième fréquence $\nu_H$ lorsqu'il est pompé électriquement ou optiquement de manière à amplifier le faisceau laser intra-cavité (FI)
   - au moins un élément biréfringent (EB) adapté(s) pour présenter une biréfringence telle que le faisceau laser intra-cavité (FI) présente la première fréquence $\nu_V$ selon la première polarisation linéaire et présente la deuxième fréquence $\nu_H$ selon la deuxième polarisation linéaire
   - un étalon Fabry-Perot ou ladite longueur de cavité étant adapté(e) pour que le faisceau laser intra-cavité (FI) présente uniquement deux modes longitudinaux, un premier mode longitudinal à la première fréquence $\nu_V$ et un deuxième mode longitudinal à la deuxième fréquence $\nu_H$
   - un premier cristal électro-optique (EO1) dans un premier matériau présentant un premier axe optique ($\boldsymbol{x}_1$) avec une même direction que la première polarisation linéaire et comprenant une première paire d'électrodes (E1) adaptée pour appliquer au sein du premier cristal électro-optique une première tension $V_1$ selon une direction de la première polarisation linéaire
   - un deuxième cristal électro-optique (EO2) dans un deuxième matériau présentant un deuxième axe optique ($\boldsymbol{x}_2$) avec une même direction que la deuxième polarisation linéaire et comprenant une deuxième paire d'électrodes (E2) adaptée pour appliquer au sein du deuxième cristal électro-optique une deuxième tension $V_2$ selon une direction de la deuxième polarisation linéaire, **caractérisé en ce que**

   le premier et le deuxième matériaux sont adaptés pour qu'il existe une première et une deuxième tensions $V_1, V_2$ adaptées pour contrôler indépendamment une valeur de la première fréquence $\nu_V$ et une valeur de la deuxième fréquence $\nu_H$ comprises dans le faisceau de sortie (FS).

2. Source laser selon la revendication 1, dans laquelle, pour une première tension $V_1$ appliquée au sein du premier cristal électro-optique et pour une deuxième tension $V_2$ appliquée au sein du deuxième cristal électro-optique, la première fréquence $\nu_V$ varie d'une valeur $\Delta\nu_V(V_1, V_2)$ et la deuxième fréquence $\nu_H$ varie d'une valeur $\Delta\nu_H(V_1, V_2)$ telles qu'on obtient le système d'équation suivant :

$$\begin{cases} \Delta\nu_V(V_1, V_2) = aV_1 + bV_2 \\ \Delta\nu_H(V_1, V_2) = cV_1 + dV_2 \end{cases}$$

   avec a et c des coefficients dépendant de la susceptibilité électrique du premier matériau et avec b et d des coefficients dépendant de la susceptibilité électrique du deuxième matériau
   le premier matériau et le deuxième matériau étant tels qu'un discriminant du système d'équation soit supérieur à 0.

3. Source laser selon la revendication 1 ou 2, comprenant un demi-VCSEL comprenant une région à gain formant ledit milieu actif et comprenant un miroir inférieur de Bragg formant ledit élément hautement réfléchissant (M1), ledit au moins élément biréfringent étant un composant distinct du milieu actif.

4. Source laser selon la revendication 3, dans laquelle le milieu actif est pompé optiquement par un premier faisceau de pompe (FP1) présentant une puissance supérieure à 500mW sur une première région (R1) et par un deuxième faisceau (FP2) de pompe présentant une puissance supérieure à 500mW sur une deuxième région (R2) distincte de la première région.

**5.** Source laser selon la revendication 4, dans laquelle la première région est séparée de la deuxième région d'une distance inférieure à 1 mm et préférentiellement comprise entre 50 $\mu m$ et 200 $\mu m$.

**6.** Source laser selon la revendication 4 ou 5, dans laquelle le premier et le deuxième faisceaux de pompe sont obtenus à partir d'un faisceau principal de pompe via une lame séparatrice en intensité insensible à la polarisation.

**7.** Source laser selon la revendication 1 ou 2, dans laquelle ledit milieu actif est un verre dopé présentant une biréfringence telle que ledit au moins élément biréfringent soit formé par ledit verre dopé.

**8.** Source laser selon la revendication 7, dans laquelle la cavité comprend un élément absorbant non linéaire du faisceau intra-cavité, par exemple un absorbant saturable ou un absorbant à deux photons, adapté pour optimiser une dynamique de bruit de la source laser.

**9.** Source laser selon l'une quelconque des revendications précédentes, dans laquelle le premier et le deuxième matériaux présentent un dopage en oxyde de magnésium.

**10.** Source laser selon l'une quelconque des revendications précédentes dans laquelle le premier et le deuxième matériaux sont en tantalate de lithium stœchiométrique dopé en oxyde de magnésium.

**11.** Source laser selon l'une quelconque des revendications précédentes, dans laquelle le premier et le deuxième matériaux sont identiques et dans laquelle le premier cristal électro-optique présente une première dimension $l_1$ selon ledit axe optique et le deuxième cristal électro-optique présente une deuxième dimension $l_2$ selon l'axe optique telle que $0.9 \times l_1 \le l_2 \le 0.99 \times l_1$ ou $1.01 \times l_1 \le l_2 \le 1.1 \times l_1$.

**12.** Source laser selon l'une quelconque des revendications précédentes comprenant ledit étalon Fabry-Pérot adapté pour que le faisceau laser intra-cavité (FI) présente uniquement deux modes longitudinaux, ledit étalon Fabry-Pérot présentant une biréfringence.

**13.** Source laser selon l'une des revendications 1 à 11 ne comprenant pas un étalon Fabry-Pérot adapté pour que le faisceau laser intra-cavité (FI) présente uniquement deux modes longitudinaux, un premier mode longitudinal à la première fréquence $v_V$ et un deuxième mode longitudinal à la deuxième fréquence $v_H$, et dans laquelle le premier ou le deuxième cristal électro-optique présente une face avec un traitement partiellement réfléchissant de manière à ce que ladite face forme ledit coupleur de sortie.

**14.** Source laser selon l'une quelconque des revendications précédentes, comprenant un premier ensemble d'asservissement relié au premier cristal électro-optique et au deuxième cristal électro-optique et adapté pour effectuer un asservissement de la première fréquence $v_V$ et de la deuxième fréquence $v_H$ indépendamment l'une de l'autre, via une commande de la première tension et de la deuxième tension.

**15.** Source laser selon l'une quelconque des revendications précédentes, dans lequel ledit coupleur de sortie est monté sur une platine de translation piézoélectrique (PTZ), ladite source laser comprenant un premier ensemble d'asservissement relié à ladite platine de translation et adapté pour effectuer un asservissement de la première fréquence $v_V$ et de la deuxième fréquence $v_H$ via une commande de la longueur de la cavité, de manière à compenser des dérives long terme du premier mode longitudinal et du deuxième mode longitudinal.

**Patentansprüche**

**1.** Abstimmbare, bipolare und bifrequente Laserquelle (1), die geeignet ist, einen Ausgangsstrahl (FS) auszusenden, der eine erste Frequenz $v_V$ gemäß einer ersten linearen Polarisation und eine zweite Frequenz $v_H$ gemäß einer zweiten linearen Polarisation aufweist, die senkrecht zur ersten linearen Polarisation steht, wobei die Laserquelle einen optischen Resonator (C) aufweist, der geeignet ist, einen Laserintraresonatorstrahl (FI) zwischen folgenden Elementen zu propagieren:

- einem hochreflektierenden Element (M1) für die erste Frequenz $v_V$ und die zweite Frequenz $v_H$, und
- einem Ausgangskoppler (M2), der geeignet ist, einen Teil des Laserintraresonatorstrahls (FI) zu transmittieren, um den Ausgangsstrahl zu bilden, und einen anderen Teil des Laserintraresonatorstrahls (FI) zu reflektieren, wobei ein Abstand (L) zwischen dem hochreflektierenden Element (M1) und dem Ausgangskoppler als Resonatorlänge bezeichnet wird,

wobei der optische Resonator (C) folgende zwischen dem hochreflektierenden Element (M1) und dem Ausgangskoppler (M2) angeordnete Elemente umfasst:

- ein aktives Medium (MA), das geeignet ist, bei elektrischer oder optischer Anregung eine optische Verstärkung für die erste Frequenz $v_V$ und die zweite Frequenz $v_H$ wenn es elektrisch oder optisch gepumpt wird, um den Laserstrahl innerhalb des Resonators (FI) zu verstärken.
- mindestens ein doppelbrechendes Element (EB), das geeignet ist, eine Doppelbrechung aufzuweisen, so dass der Laserintraresonatorstrahl (FI) die erste Frequenz $v_V$ gemäß der ersten linearen Polarisation und die zweite Frequenz $v_H$ gemäß der zweiten linearen Polarisation aufweist,
- ein Fabry-Perot-Etalon oder die genannte Resonatorlänge, die geeignet ist/sind, dass der Laserintraresonatorstrahl (FI) nur zwei longitudinale Moden aufweist, einen ersten longitudinalen Modus bei der ersten Frequenz $v_V$ und einen zweiten longitudinalen Modus bei der zweiten Frequenz $v_H$
- einen ersten elektrooptischen Kristall (EO1) in einem ersten Material, das eine erste optische Achse ($x_1$) mit einer gleichen Richtung wie die erste lineare Polarisation aufweist und ein erstes Paar Elektroden (E1) aufweist, das geeignet ist, innerhalb des ersten elektrooptischen Kristalls eine erste Spannung $V_1$ gemäß einer Richtung der ersten linearen Polarisation anzulegen,
- einen zweiten elektrooptischen Kristall (EO2) in einem zweiten Material, das eine zweite optische Achse ($x_2$) mit einer gleichen Richtung wie die zweite lineare Polarisation aufweist und ein zweites Paar Elektroden (E2) aufweist, das geeignet ist, innerhalb des zweiten elektrooptischen Kristalls eine zweite Spannung $V_2$ gemäß einer Richtung der zweiten linearen Polarisation anzulegen, **dadurch gekennzeichnet, dass**

das erste und das zweite Material geeignet sind, sodass eine erste und eine zweite Spannung $V_1$, $V_2$ existieren, die geeignet sind, einen Wert der ersten Frequenz $v_V$ und einen Wert der zweiten Frequenz $v_H$ die im Ausgangsstrahl (FS) enthalten sind, unabhängig voneinander zu steuern.

2. Laserquelle nach Anspruch 1, wobei bei einer am ersten elektrooptischen Kristall angelegten ersten Spannung $V_1$ und einer am zweiten elektrooptischen Kristall angelegten zweiten Spannung $V_2$ die erste Frequenz $v_V$ um einen Wert $\Delta v_V$ ($V_1$, $V_2$) und die zweite Frequenz $v_H$ um einen Wert $\Delta v_H(V_1, V_2)$ variieren, so dass'man das folgende Gleichungssystem erhält:

$$\begin{cases}\Delta v_V(V_1, V_2) = aV_1 + bV_2 \\ \Delta v_H(V_1, V_2) = cV_1 + dV_2\end{cases}$$

mit a und c Koeffizienten, die von der elektrischen Suszeptibilität des ersten Materials abhängen, und mit b und d Koeffizienten, die von der elektrischen Suszeptibilität des zweiten Materials abhängen, wobei das erste Material und das zweite Material so beschaffen sind, dass eine Diskriminante des Gleichungssystems größer als 0 ist.

3. Laserquelle nach Anspruch 1 oder 2, umfassend einen Halb-VCSEL, der eine Verstärkungsregion, die das genannte aktive Medium bildet, und einen unteren Bragg-Spiegel, der das genannte hochreflektierende Element (M1) bildet, umfasst, wobei das genannte mindestens eine doppelbrechende Element eine vom aktiven Medium separate Komponente ist.

4. Laserquelle nach Anspruch 3, wobei das aktive Medium optisch durch einen ersten Pumpstrahl (FP1) mit einer Leistung von mehr als 500 mW in einem ersten Bereich (R1) und durch einen zweiten Pumpstrahl (FP2) mit einer Leistung von mehr als 500 mW in einem zweiten, vom ersten Bereich verschiedenen Bereich (R2) angeregt wird.

5. Laserquelle nach Anspruch 4, wobei der erste Bereich vom zweiten Bereich um einen Abstand von weniger als 1 mm und vorzugsweise zwischen 50 $\mu$m und 200 $\mu m$ getrennt ist.

6. Laserquelle nach Anspruch 4 oder 5, wobei der erste und der zweite Pumpstrahl aus einem Hauptpumpstrahl über einen polarisationsunempfindlichen Intensitäts-Strahlteiler erhalten werden.

7. Laserquelle nach Anspruch 1 oder 2, wobei das genannte aktive Medium ein dotiertes Glas ist, das eine Doppelbrechung aufweist, so dass das genannte mindestens eine doppelbrechende Element durch das genannte dotierte Glas gebildet wird.

8. Laserquelle nach Anspruch 7, wobei der Resonator ein nichtlineares, den Intraresonatorstrahl absorbierendes Element, beispielsweise einen sättigbaren Absorber oder einen Zwei-Photonen-Absorber, aufweist, das geeignet ist, eine Rauschdynamik der Laserquelle zu optimieren.

9. Laserquelle nach einem der vorstehenden Ansprüche, wobei das erste und das zweite Material eine Dotierung mit Magnesiumoxid aufweisen.

10. Laserquelle nach einem der vorstehenden Ansprüche, wobei das erste und das zweite Material aus mit Magnesiumoxid dotiertem stöchiometrischem Lithiumtantalat bestehen.

11. Laserquelle nach einem der vorstehenden Ansprüche, wobei das erste und das zweite Material identisch sind und wobei der erste elektrooptische Kristall eine erste Abmessung $l_1$ gemäß der genannten optischen Achse und der zweite elektrooptische Kristall eine zweite Abmessung $l_2$ gemäß der optischen Achse aufweist, so dass $0{,}9 \times l_1 \le l_2 \le 0{,}99 \times l_1$ oder $1{,}01 \times l_1 \le l_2 \le 1{,}1 \times l_1$ gilt.

12. Laserquelle nach einem der vorstehenden Ansprüche, umfassend das genannte Fabry-Perot-Etalon, das geeignet ist, dass der Laserintraresonatorstrahl (FI) nur zwei longitudinale Moden aufweist, wobei das genannte Fabry-Perot-Etalon eine Doppelbrechung aufweist.

13. Laserquelle nach einem der Ansprüche 1 bis 11, die kein Fabry-Perot-Etalon, das geeignet ist, dass der Laserintraresonatorstrahl (FI) nur zwei longitudinale Moden aufweist, einen ersten longitudinalen Modus bei der ersten Frequenz $v_V$ und einen zweiten longitudinalen Modus bei der zweiten Frequenz $v_H$, aufweist und wobei der erste oder der zweite elektrooptische Kristall eine Fläche mit einer teildurchlässigen Beschichtung aufweist, so dass die genannte Fläche den genannten Ausgangskoppler bildet.

14. Laserquelle nach einem der vorstehenden Ansprüche, umfassend eine erste Regelungsanordnung, die mit dem ersten elektrooptischen Kristall und dem zweiten elektrooptischen Kristall verbunden und geeignet ist, eine Regelung der ersten Frequenz $v_V$ und der zweiten Frequenz $v_H$ unabhängig voneinander über eine Steuerung der ersten Spannung und der zweiten Spannung durchzuführen.

15. Laserquelle nach einem der vorstehenden Ansprüche, wobei der genannte Ausgangskoppler auf einer piezoelektrischen Translationsbühne (PTZ) montiert ist, wobei die genannte Laserquelle eine erste Anordnung aufweist, die mit der genannten Translationsbühne verbunden und geeignet ist, eine Regelung der ersten Frequenz $v_V$ und der zweiten Frequenz $v_H$ über eine Steuerung der Resonatorlänge durchzuführen, um Langzeitdrifts des ersten longitudinalen Modus und des zweiten longitudinalen Modus zu kompensieren.

## Claims

1. Dual-frequency bi-polarisation tunable laser source (1) adapted to emit an output beam (FS) having a first frequency $v_V$ along a first linear polarisation and a second frequency $v_H$ along a second linear polarisation perpendicular to the first linear polarisation, the laser source comprising an optical cavity (C) adapted to propagate an intra-cavity laser beam (FI) between:

   - a highly reflective element (M1) at the first frequency $v_V$ and at the second frequency $v_H$, and
   - an output coupler (M2) adapted to transmit a portion of the intra-cavity laser beam (FI) so as to form the output beam and to reflect another portion of the intra-cavity laser beam (FI), a distance (L) between the highly reflective element (M1) and the output coupler being called cavity length,

   the optical cavity (C) comprising the following elements disposed between the highly reflective element (M1) and the output coupler (M2):

   - an active medium (MA) adapted to have an optical gain at the first frequency $v_V$ and at the second frequency $v_H$ when it is electrically or optically pumped, so as to amplify the intra-cavity laser beam (FI)
   - at least one birefringent element (EB) adapted to have a birefringence such that the intra-cavity laser beam (FI) has the first frequency $v_V$ along the first linear polarisation and has the second frequency $v_H$ along the second linear polarisation

- a Fabry-Perot etalon or said cavity length being adapted such that the intra-cavity laser beam (FI) only has two longitudinal modes, a first longitudinal mode at the first frequency $v_V$ and a second longitudinal mode at the second frequency $v_H$

- a first electro-optical crystal (EO1) made of a first material having a first optical axis ($x_1$) with one same direction as the first linear polarisation and comprising a first pair of electrodes (E1) adapted to apply within the first electro-optical crystal, a first voltage $V_1$ along a direction of the first linear polarisation

- a second electro-optical crystal (EO2) made of a second material having a second optical axis ($x_2$) with one same direction as the second linear polarisation and comprising a second pair of electrodes (E2) adapted to apply within the second electro-optical crystal, a second voltage $V_2$ along a direction of the second linear polarisation, **characterised in that**

the first and the second materials are adapted such that there is a first and a second voltage $V_1$, $V_2$ adapted to independently control a value of the first frequency $v_V$ and a value of the second frequency $v_H$ comprised in the output beam (FS).

2. Laser source according to claim 1, wherein, for a first voltage $V_1$ applied within the first electro-optical crystal and for a second voltage $V_2$ applied within the second electro-optical crystal, the first frequency $v_V$ varies from a value $\Delta v_V(V_1, V_2)$ and the second frequency $v_H$ varies from a value $\Delta v_H(V_1, V_2)$ such thatthe system of the following equation is obtained:

$$\begin{cases} \Delta v_V(V_1, V_2) = aV_1 + bV_2 \\ \Delta v_H(V_1, V_2) = cV_1 + dV_2 \end{cases}$$

with a and c of the coefficients depending on the electrical susceptibility of the first material and with b and d of the coefficients depending on the electrical susceptibility of the second material
the first material and the second material being such that a discriminant of the equation system is greater than 0.

3. Laser source according to claim 1 or 2, comprising a half-VCSEL comprising a gain region forming said active medium and comprising a lower Bragg mirror forming said highly reflective element (M1), said at least the bifringent element being a component distinct from the active medium.

4. Laser source according to claim 3, wherein the active medium is optically pumped by a first pump beam (FP1) having a power greater than 500mW on a first region (R1) and by a second pump beam (FP2) having a power greater than 500mW on a second region (R2) distinct from the first region.

5. Laser source according to claim 4, wherein the first region is separated from the second region of a distance less than 1mm and preferably between $50\mu m$ and $200\mu m$.

6. Laser source according to claim 4 or 5, wherein the first and the second pump beams are obtained from a main pump beam via a beam splitter with intensity insensitive to the polarisation.

7. Laser source according to claim 1 or 2, wherein said active medium is a doped glass having a bifringence such that said at least one bifringent element is formed by said doped glass.

8. Laser source according to claim 7, wherein the cavity comprises a non-linear absorbent element of the intra-cavity beam, for example, a saturable absorbance or a two-photon absorbent, adapted to optimise a noise dynamic of the laser source.

9. Laser source according to any one of the preceding claims, wherein the first and the second materials having a magnesium oxide doping.

10. Laser source according to any one of the preceding claims, wherein the first and the second materials are made of magnesium oxide doped stoichiometric lithium tantalate.

11. Laser source according to any one of the preceding claims, wherein the first and the second materials are identical and wherein the first electro-optical crystal has a first dimension $l_1$ along said optical axis and the second electro-optical crystal has a second dimension $l_2$ along the optical axis such that $0.9 \times l_1 \le l_2 \le 0.99 \times l_1$ or $1.01 \times l_1 \le l_2 \le 1.1 \times l_1$.

12. Laser source according to any one of the preceding claims comprising said Fabry-Perot etalon adapted such that the intra-cavity laser beam (FI) only has two longitudinal modes, said Fabry-Perot etalon having a bifringence.

13. Laser source according to any one of claims 1 to 11 not comprising a Fabry-Perot etalon adapted such that the intra-cavity laser beam (FI) only has two longitudinal modes, a first longitudinal mode at the first frequency $v_V$ and a second longitudinal mode at the second frequency $v_H$, and wherein the first or the second electro-optical crystal has a face with a partially reflective treatment, such that said face forms said output coupler.

14. Laser source according to any one of the preceding claims, comprising a first service pack connected to the first electro-optical crystal and to the second electro-optical crystal and adapted to perform a service of the first frequency $v_V$ and of the second frequency $v_H$ independently from one another, via a control of the first voltage and of the second voltage.

15. Laser source according to any one of the preceding claims, wherein said output coupler is mounted on a piezoelectric translation plate (PTZ), said laser source comprising a first service pack connected to said translation plate and adapted to perform a service of the first frequency $v_V$ and of the second frequency $v_H$ via a control of the length of the cavity, so as to compensate for the long-term drifts of the first longitudinal mode and of the second longitudinal mode.

[Fig.1]

FIG.1

[Fig.2A]

**Niveau excité commun**

$\nu_1$

$\nu_2$

$\nu_0$

**Niveaux hyperfins fondamentaux**

FIG.2A

[Fig.2B]

Résonance noire
(*Coherent Population Trapping* – CPT)

$$\nu_2 - \nu_1 = \nu_0$$

Transmission

Désaccord en fréquence [MHz]

FIG.2B

EP 4 542 795 B1

[Fig.3]

FIG.3

22

[Fig.4]

<u>1</u>

FIG.4

[Fig.5]

FIG.5

[Fig.6]

$\underline{1}$

FIG.6

[Fig.7]

FIG.7

[Fig.8]

FIG.8

[Fig.9]

FIG.9

[Fig.10]

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2886478 A1

**Littérature non-brevet citée dans la description**

- **L. MORVAN** ; **D. DOLFI** ; **J.P.HUIGNARD** ; **S. BLANC** ; **M. BRUNEL** ; **F. BRETENAKER** ; **M. VALLET** ; **A. LE FLOCH**. Dual-frequency laser at 1.53 μm for generating high purity optically carried microwave signals up to 20 GHz. *CLEO, paper CtuL5*, 2004
- **M. ALOUINI** ; **B. BENAZET** ; **M. VALLET** ; **M. BRUNEL** ; **P. DI BIN** ; **F. BRETENAKER** ; **A. LE FLOCH** ; **P. THONY**. Offset phase locking of Er:Yb:Glass laser eigenstates for RF photonics applications. *IEEE Photonics Technology Letters*, 2001, vol. 13, 367-369
- Towards the detection of high-contrast Cs CPT resonances using a single modulated diode laser. EUROPEAN FREQUENCY AND TIME FORUM (EFTF). IEEE, 23 April 2012, 304-308
- **A. EL AMILI** ; **M. ALOUINI**. Experimental evidence and theoretical modeling of two-photon absorption dynamics in the reduction of intensity noise of solid-state Er:Yb lasers. *Opt. lett*, 2013, vol. 21 (7), 1926